# FASCICULE DE BREVET EUROPEEN

(11) **EP 2 831 920 B1**
(45) Date de publication et mention de la délivrance du brevet: **11.05.2016**
(21) Numéro de dépôt: 13719933.7
(22) Date de dépôt: 28.03.2013
(51) Int. Cl.: H01L 31/0749, H01L 31/0392, H01L 31/0232, H01L 31/0216

(54) **STRUCTURE DE CELLULE PHOTOVOLTAÏQUE EN COUCHES MINCES AVEC UNE COUCHE MIROIR.**
FOTOVOLTAISCHEN DÜNNSCHICHTZELLENSTRUKTUR MIT EINER SPIEGELSCHICHT
THIN-FILM PHOTOVOLTAIC CELL STRUCTURE WITH A MIRROR LAYER

(30) Priorité: 29.03.2012 FR 1252835
(43) Date de publication de la demande: 04.02.2015
(73) Titulaire: Centre National de la Recherche Scientifique (CNRS), 75794 Paris Cedex 16 (FR); Electricité de France, 75008 Paris (FR)
(72) Inventeur: NAGHAVI, Negar, F-75016 Paris (FR); JEHL, Zacharie, F-75020 Paris (FR); LINCOT, Daniel, F-92160 Antony (FR); GUILLEMOLES, Jean-François, F-75013 Paris (FR)
(74) Mandataire: Cabinet Plasseraud
(86) Numéro de dépôt international: PCT/FR2013/050667
(87) Numéro de publication internationale: WO 2013/144511

(56) Documents cités:
- EP-A1- 2 040 304
- WO-A1-2005/088731
- US-A1- 2010 248 413
- MALMSTROM J ET AL: "Potential for light trapping in Cu(In,Ga)Se2 solar cells", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 mai 2003 (2003-05-18), pages 344-347Vol.1, XP031987577, ISBN: 978-4-9901816-0-4
- TAKASHI MINEMOTO ET AL: "Lift-Off Process for Flexible Cu(In,Ga)Se2 Solar Cells", JAPANESE JOURNAL OF APPLIED PHYSICS, JAPAN SOCIETY OF APPLIED PHYSICS, JP, vol. 49, no. 4, 20 avril 2010 (2010-04-20) , pages 4DP06-1, XP001554752, ISSN: 0021-4922, DOI: 10.1143/JJAP.49.04DP06 [extrait le 2010-04-20]

## Description

La présente invention concerne une structure de cellule photovoltaïque destinée à des applications dans les panneaux solaires.

Elle traite plus particulièrement d'une structure en couches minces comportant au moins une couche d'alliage I-III-VI₂ à propriétés photovoltaïques notamment pour la conversion de la lumière solaire en électricité.

Il a été observé que les cellules photovoltaïques à base d'alliage I-III-VI₂ à propriétés photovoltaïques présentent un rendement maximal pour des cellules en couches minces, supérieur en particulier aux cellules de Tellurure de Cadmium (CdTe) et Silicium (Si) en couches minces. Dans cet alliage I-III-VI₂, l'élément I de la colonne périodique peut être par exemple du cuivre, l'élément III de l'indium, du gallium et/ou de l'aluminium, l'élément VI du sélénium et/ou du soufre. Cet alliage est aussi nommé ci-après CIGS (avec C pour Cuivre, I pour Indium, G pour Gallium, et S pour Soufre et/ou Sélénium). En effet, pour un coût de fabrication faible et sensiblement équivalent à une cellule à base de CdTe, une cellule à base de CIGS peut présenter un rendement de 3 à 5% supérieur.

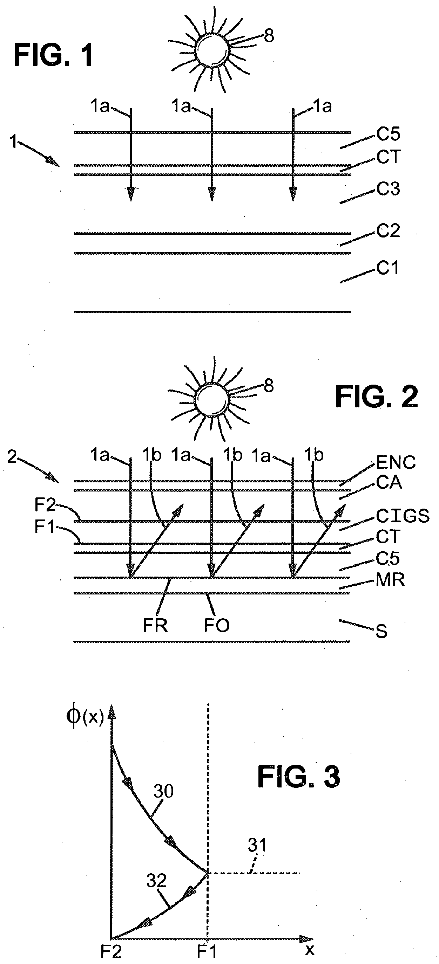

En référence à la figure 1, on a représenté une vue en coupe d'un mode de réalisation possible de structure classique de cellule photovoltaïque 1 à base d'alliage I-III-VI₂. Une telle structure comprend un empilement de couches minces dont, par exemple :
- un substrat C1 à base de verre, en tant que support, fréquent dans l'art antérieur, de l'empilement de couches minces de la cellule 1 ;
- une couche de contact C2, souvent à base de molybdène (Mo), formant une première électrode de la cellule ;
- une couche C3, à propriétés photovoltaïques, à base d'alliage I-III-VI₂ (avec par exemple un alliage de CIGS) ;
- une couche CT à base de sulfure de cadmium (CdS), de sulfure de zinc (ZnS), ou de sulfure d'indium (In₂S₃), laquelle est une couche d'interface de la cellule 1 (nommée couche tampon par la suite) ; et
- une couche C5, transparente et conductrice, formant une deuxième électrode, souvent composée essentiellement d'oxyde de zinc (ZnO).

La cellule 1 photovoltaïque d'alliage I-III-VI₂ peut être exposée à une source d'éclairement 8 (typiquement le soleil dans une application de panneau solaire). A titre illustratif, la source 8 peut éclairer la cellule 1 selon des rayons lumineux 1a, suivant un sens de propagation de la source 8 vers la cellule 1. La face par laquelle entre la lumière solaire est appelée ci-après « face avant » de la cellule.

D'une part, dans cet exemple, la couche C2 à base de molybdène (Mo) est en contact avec la couche C3 de CIGS (semi-conductrice de type p), laquelle couche de molybdène (Mo) constitue une électrode arrière de la cellule 1 (électrode en arrière de la cellule par rapport au sens de propagation des rayons lumineux 1a dans la cellule 1). L'électrode arrière définit alors une face opposée à la face avant précitée, et appelée ci-après « face arrière » de la cellule. La couche de molybdène (Mo) joue le rôle d'un contact électrique très peu résistant (dit « contact ohmique »).

D'autre part, la couche C5 à base d'oxyde de zinc (ZnO) est en contact avec la couche tampon CT laquelle est en contact avec la couche C3 de CIGS. La couche CT et la couche C5 sont transparentes à la lumière en provenance de la source 8 de sorte que la couche de CIGS est exposée aux rayons lumineux 1a. La couche C3 à base de CIGS possède des propriétés photovoltaïques qui lui permettent de convertir cette lumière en électricité. Dans cet exemple de réalisation, la couche C5 à base d'oxyde de zinc (ZnO) peut constituer une électrode avant transparente et conductrice de la cellule 1. L'interface entre la couche de CIGS et les couches CT et C5 est caractérisée par le fait qu'elle présente un contact électrique de diode, du fait de la réalisation d'une jonction p-n entre le CIGS et les couches CT et C5.

Le rendement d'une telle cellule, et donc la quantité d'énergie électrique obtenue à partir de cette cellule, sont particulièrement dépendants de deux facteurs qui sont :
- l'épaisseur de la couche mince C3 à propriétés photovoltaïques, et
- l'intensité de la lumière reçue par cette couche mince C3.

Une solution pour améliorer le rendement d'une cellule classique consisterait à augmenter l'épaisseur de la couche mince à base d'alliage I-III-VI₂ et/ou à accroître l'intensité de la lumière l'éclairement à laquelle est exposée cette cellule.

Or, dans le cadre de l'application de la cellule 1 dans un panneau solaire, l'intensité de la lumière est dépendante de l'éclairement naturel du soleil auquel est exposée la cellule. Dans une configuration standard telle que représentée dans la figure 1 où l'empilement est directement exposé au soleil, on ne peut forcer ce facteur pour améliorer le rendement.

Par ailleurs, un alliage I-III-VI₂ à propriétés photovoltaïques est composé particulièrement d'éléments chimiques avec une disponibilité limitée. A titre d'exemple purement illustratif, l'alliage de CIGS comprend l'élément chimique indium (In) dont l'extraction annuelle mondiale actuelle n'excède pas 600 tonnes. Typiquement, pour une production de cellules photovoltaïques aptes à produire 1 GW, 38 tonnes d'Indium par an sont utilisées pour des cellules présentant un rendement de 10% avec une épaisseur de couche mince de CIGS de 2 microns.

| Rendement | Epaisseur de CIGS (micron) | | |
|---|---|---|---|
| | 2 microns | 1 micron | 0.1 micron |
| 10% | 38 t/GW | 19 | 1.9 |
| 15% | 24 | 12 | 1.2 |

Le tableau ci-dessus représente une évaluation de la quantité d'indium utilisée pour la production de 1 GW de puissance photovoltaïque à partir de couches minces de CIGS de différentes épaisseurs, ainsi que de différents rendements de conversion.

Quand bien même le rendement serait supérieur, par exemple de 15%, 24 tonnes par an seraient encore utilisées. On comprendra qu'à long terme, la disponibilité d'indium limitera la production des cellules à base de CIGS.

Selon une étude récente, « Renewable and Sustainable Energy Reviews » (13(9), 2746-2750, 2009), la croissance de l'utilisation de telles cellules permettrait d'atteindre une production de 20 GW par an jusqu'en 2020, puis pourrait être ensuite limitée à cette production compte tenu de la disponibilité restreinte précitée.

Une augmentation de l'épaisseur de la couche mince d'alliage I-III-VI₂ dans les cellules photovoltaïques ne convient donc pas en vue d'une augmentation de la production de cellules.

Notons que WO 2005 088731 divulgue une cellule CIGS comportant une couche miroir ce qui permet une réduction de l'épaisseur de la couche CIGS à rendement équivalent par rapport à une cellule CIGS classique sans couche miroir.

La présente invention vient améliorer la situation pour permettre l'utilisation de couches d'alliage I-III-VI₂ plus fines avec un rendement au moins équivalent, permettant ainsi de réduire de façon significative l'utilisation d'indium (comme indiqué précédemment en correspondance du tableau ci-dessus).

Elle vise à cet effet une structure de cellule photovoltaïque en couches minces comportant au moins une couche d'alliage I-III-VI₂ à propriétés photovoltaïques pour la conversion d'une lumière d'éclairement en électricité.

La structure selon l'invention comporte en outre au moins :
- une couche miroir avec une face réfléchissante d'une partie de la lumière d'éclairement, laquelle face réfléchissante est en regard d'une première face de la couche d'alliage I-III-VI₂ pour recevoir sur la première face une lumière d'éclairement réfléchie, et
- une ou plusieurs premières couches transparentes à la lumière d'éclairement pour recevoir une lumière d'éclairement transmise sur une deuxième face de la couche d'alliage I-III-VI₂ opposée à la première face.

On comprendra ainsi que la première face de la couche d'alliage I-III-VI₂ se situe « en face arrière » d'une cellule comportant une telle structure au sens de l'invention, tandis que la deuxième face de la couche d'alliage I-III-VI₂ se situe « en face avant » de la cellule comportant une telle structure.

Ainsi, la couche mince d'alliage I-III-VI₂ de la cellule photovoltaïque reçoit une lumière d'éclairement transmise (éclairement direct) par sa deuxième face et une lumière d'éclairement réfléchie (éclairement indirect) par sa première face, laquelle première face est en regard de la face réfléchissante de la couche miroir.

De la sorte, l'éclairement cumulé, direct et réfléchi, de la couche d'alliage I-III-VI₂ est supérieur à l'éclairement dans une structure au sens de l'état de l'art (à couche photovoltaïque de même épaisseur), et ce grâce à la couche miroir, ce qui améliore le rendement de la cellule par rapport à une cellule photovoltaïque classique.

On comprendra alors que le surcroit d'éclairement induit par la lumière d'éclairement réfléchie permet de prévoir une épaisseur de couche d'alliage I-III-VI₂ moindre dans la structure de cellule en conservant un rendement sensiblement équivalent à une cellule classique.

La réduction d'épaisseur de la couche d'alliage I-III-VI₂ limite la quantité de matière utilisée pour la production d'une cellule photovoltaïque (et notamment la quantité d'indium dans le cadre d'une couche de CIGS) sans compromettre le rendement de cette dernière.

Avantageusement, la couche miroir est une couche métallique conductrice. Ainsi, elle peut constituer une l'électrode arrière de la cellule, en remplacement par exemple de l'électrode de contact arrière ou « back contact » habituellement en molybdène très peu réfléchissante.

Elle peut typiquement être réalisée dans un métal ou dans un alliage de métaux choisis parmi la liste: aluminium (Al), nickel (Ni), argent (Ag), or (Au), platine (Pt), ou cuivre (Cu).

Une couche d'interface peut être introduite entre la couche miroir et la couche de CIGS de façon à optimiser les propriétés électriques et optiques de ce contact.

En variante, la couche «miroir» précitée peut être une couche non métallique mais diffusive et comprend un revêtement réfléchissant. Dans le cadre de cette réalisation, au moins une couche transparente et conductrice est placée entre la couche miroir et la couche d'alliage I-III-VI₂ pour jouer avantageusement le rôle d'électrode arrière de la cellule en assurant un contact ohmique peu résistif avec la couche photovoltaïque.

On comprendra alors que l'on entend ci-avant par « couche miroir » une couche apte à renvoyer de manière générale, par réflexion ou par diffusion, la lumière vers la première face précitée de la couche photovoltaïque (face correspondant à la jonction p-n de la couche photovoltaïque).

Dans une réalisation, la structure comporte, entre la couche miroir et la couche d'alliage I-III-VI₂, une ou plusieurs secondes couches transparentes à la lumière d'éclairement. On entend ici par «couches transparentes à la lumière d'éclairement» la propriété de ces couches à laisser passer la lumière dans une gamme de longueurs d'onde particulières, typiquement de 350 à 1100 nm (spectre solaire) pour une application de la cellule photovoltaïque dans un panneau solaire. Ces secondes couches transparentes peuvent comporter avantageusement une structure correspondant à la structure traditionnelle avant des cellules avec au moins une couche mince à base d'oxyde de zinc (ZnO) et/ou une couche tampon réalisée parmi les matériaux classiques tels que :
- le sulfure de cadmium (CdS),
- le sulfure de zinc (ZnS),
- le sulfure d'indium (In₂S₃),
- ou autre.

Ainsi, au moins l'une de ces « secondes couches » précitées peut être à la fois transparente et électriquement conductrice pour former l'électrode arrière de la cellule, par exemple, lorsque la couche «miroir» précitée n'est pas conductrice.

On comprendra ainsi que dans cette structure, les secondes couches sont disposées entre la couche miroir et la couche d'alliage photovoltaïque. De cette manière, la jonction n-p de la cellule (zone où l'effet photovoltaïque est le plus efficace) formée par l'interface entre la couche d'alliage I-III-VI₂ et la couche tampon, est située en arrière de la couche d'alliage (en arrière par rapport au sens de propagation de la lumière dans la cellule). Dans une configuration de cellule classique (comme illustrée à la figure 1), cette interface est située en avant de la couche d'alliage I-III-VI₂.

L'efficacité de l'éclairement, dans cette configuration, pour générer de la puissance électrique, est possible grâce à une épaisseur réduite de la couche d'alliage I-III-VI₂ (inférieure à 0,5 micron).

Avantageusement, la couche miroir permet en outre d'améliorer la stabilité de la cellule photovoltaïque en isolant plus efficacement la couche d'oxyde de zinc (ZnO) et l'interface fragile ZnO-CT-CIGS (notamment sensibles à l'humidité). Ainsi, des conditions de fabrication moins contraignantes conviennent pour la production de cellules.

Dans la structure au sens de l'invention, la lumière peut entrer via la deuxième face précitée de la couche d'alliage I-III-VI₂ (face opposée à celle comportant la jonction p-n), à condition de réaliser un nouveau contact avant qui soit transparent et conducteur. Ainsi, des premières couches transparentes sont déposées sur cette face. L'une desdites premières couches transparentes comporte donc préférentiellement au moins une couche conductrice. En l'espèce, cette couche conductrice peut jouer le rôle d'électrode avant dans la structure, tandis que la couche miroir ou la couche conductrice des secondes couches précitées joue le rôle d'électrode arrière.

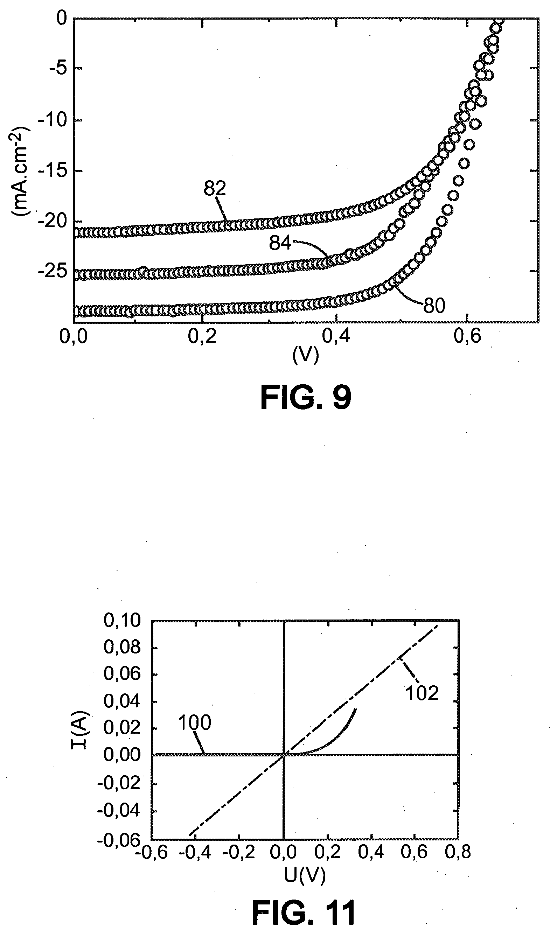

Dans ce mode de réalisation, il est avantageux d'intercaler une couche intercalaire transparente entre la couche d'alliage I-III-VI₂ et la couche transparente conductrice constituant le contact avant. Une telle couche intercalaire (nommée « couche d'interface » par la suite) permet de créer un contact ohmique peu résistif comme on le verra plus loin en référence à la figure 11. A cet effet, la couche d'interface peut être une couche à base d'un semi-conducteur transparent à grande largeur de bande interdite de type oxyde, sulfure, séléniure, nitrure, phosphure, ou encore un composé comprenant du cuivre (Cu), du gallium (Ga), de l'indium (In), de l'iode (I), du phosphore (P), de l'arsenic (As), du soufre (S), de l'azote (N), de l'oxygène (O) ou autre. En variante, dans une réalisation possible, la couche d'interface peut être une couche de cuivre de quelques nanomètres.

Cette couche d'interface est avantageuse lorsque notamment la couche miroir forme elle-même électrode. Toutefois, elle peut être avantageuse en tant que telle pour améliorer la qualité d'électrode de la couche supérieure transparente conductrice (de ZnO habituellement). Ainsi, on comprendra que cette couche d'interface est avantageuse en tant que telle sans nécessairement une implémentation dans une structure à couche miroir. Cette couche d'interface et son adjonction entre la couche photovoltaïque et la couche ZnO peut faire l'objet d'une protection séparée, indépendante d'une structure à couche miroir.

Dans une structure au sens de l'invention, il convient de protéger cette couche transparente conductrice et lesdites premières couches transparentes peuvent prévoir à cet effet au moins un revêtement superficiel d'encapsulation, amené par collage par exemple à la structure.

Dans une réalisation, la structure comporte en outre un support desdites :
- couche d'alliage I-III-VI₂,
- couche miroir, et
- une ou plusieurs premières couches transparentes.

Ce support peut être réalisé dans un matériau ayant une température de fusion inférieure ou égale à 500°C. Ce support peut être en contact, par exemple par collage, avec la couche miroir sur une face opposée à sa face réfléchissante précitée. De façon avantageuse, le support est réalisé dans un polymère de température de fusion inférieure à 300°C. Avantageusement, ce support peut être flexible. Il peut s'agir par exemple d'un polymère souple à très basse température de fusion, généralement peu onéreux.

Ainsi, la fabrication d'une structure de cellule requérant des contraintes thermiques élevées pour la formation de la couche mince d'alliage I-III-VI₂ devient compatible avec l'application de telles couches sur un support à basse température de fusion. En effet, à titre d'exemple, une température aux alentours de 550°C est habituellement préconisée pour la formation d'une couche mince à base de CIGS par un procédé de co-évaporation, pour obtenir un dépôt uniforme de cette couche dans la structure de la cellule.

Or, les contraintes thermiques inhérentes à ce procédé sont susceptibles de dénaturer les propriétés d'un support souple en tant que substrat lors de sa fabrication (si la température de fusion de ce support est inférieure à 550°C par exemple).

Comme on le verra plus loin, un procédé de fabrication de la structure au sens de l'invention propose, dans un exemple de réalisation possible, un décollement de l'empilement de couches de son substrat (ou d'une couche de molybdène) et un collage de l'empilement sur un support, qui peut être avantageusement à basse température de fusion. D'ailleurs, l'invention porte également sur un procédé de fabrication avantageux pour la production d'une cellule photovoltaïque comportant, de façon générale, une couche miroir, le procédé comprenant au moins les étapes :
a) dépôt de la couche d'alliage I-III-VI₂ sur une surface, ladite deuxième face de la couche d'alliage I-III-VI₂ étant en contact avec ladite surface,
b) dépôt de la couche miroir directement ou indirectement sur ladite première face de la couche d'alliage I-III-VI₂, opposée à la deuxième face,
c) dépôt desdites une ou plusieurs premières couches transparentes, directement ou indirectement sur ladite deuxième face de la couche d'alliage I-III-VI₂.

Dans une réalisation avantageuse, mais optionnelle toutefois, le procédé comporte en outre un décollement, comme indiqué précédemment, au moins de la couche d'alliage I-III-VI₂ de ladite surface, par la deuxième face, et ceci avant l'étape c).

Cette réalisation bien qu'avantageuse est optionnelle : en effet, il est possible de prévoir un dépôt de la couche photovoltaïque directement ou indirectement sur la couche miroir (par l'intermédiaire d'au moins une couche transparente), dès la conception de l'empilement, et sans décollement ultérieur.

Dans une réalisation, le procédé comporte en outre le dépôt d'une ou plusieurs secondes couches minces transparentes à ladite lumière d'éclairement, entre les étape a) et b), sur la première face de la couche d'alliage I-III-VI₂, la couche miroir étant déposée sur l'une desdites secondes couches minces transparentes.

Plus généralement, le procédé de fabrication de la cellule permet, de par le dépôt au préalable de la couche d'alliage I-III-VI₂ et le décollement à l'interface de celle-ci avec le substrat, d'appliquer au premier empilement des couches minces et des revêtements avec des températures de fusion inférieures ou égales aux températures élevées du procédé de formation de la couche d'alliage I-III-VI₂.

Ainsi, le nouveau support arrière peut être composé des matériaux qui étaient incompatibles avec les cellules classiques. Le nouveau support en couche arrière peut être par exemple un polymère ou autre matériau moins onéreux aux propriétés avantageuses (polymère souple par exemple).

Avantageusement, la couche d'alliage I-III-VI₂ pour la mise en oeuvre du procédé et/ou dans une structure de cellule au sens de l'invention, peut avoir une épaisseur inférieure ou égale à 0,5 micron.

De la sorte, la réduction d'épaisseur de la couche d'alliage I-III-VI₂ réduit la quantité de matière utilisée d'un facteur d'au moins 4. A titre d'exemple, avec une couche d'alliage I-III-VI₂ d'une épaisseur de 0,2 micron, on économise une quantité de matière d'un facteur de 10 par rapport à une cellule classique (2 microns d'épaisseur).

En outre, la réduction d'épaisseur de la couche d'alliage I-III-VI₂ diminue le temps de production d'une cellule photovoltaïque, la quantité de matière à appliquer étant moindre. A titre indicatif, quarante minutes d'évaporation sont généralement requises pour former une couche mince de CIGS de 2 microns dans le cadre d'une cellule photovoltaïque classique. On comprendra qu'une couche de CIGS de moins de 0,5 microns diminue considérablement le temps de coévaporation utile pour la fabrication de cette cellule.

D'autres avantages et caractéristiques de l'invention apparaîtront à la lecture de la description détaillée ci-après d'exemples de réalisations présentés à titre illustratif, aucunement limitatifs, et en référence aux dessins annexés sur lesquels :
- la figure 1 illustre une vue en coupe d'un exemple d'empilement de couches minces et son support pour une structure de cellule photovoltaïque classique ;
- la figure 2 illustre une vue en coupe d'un exemple d'empilement de couches minces et son support pour une structure de cellule photovoltaïque selon l'invention ;
- la figure 3 représente un flux lumineux traversant la couche d'alliage photovoltaïque de l'empilement de la structure de cellule (en ordonnées), en fonction de la distance (x) franchie par la lumière dans la couche photovoltaïque (en abscisses) ;
- la figure 4 illustre une vue en coupe d'un exemple de structure en couches minces obtenu à la suite de premières étapes du procédé de fabrication d'une telle structure de cellule ;
- la figure 5 illustre une vue en coupe d'un exemple d'empilement de couches minces obtenu à la suite de deuxièmes étapes du procédé de fabrication de la structure de cellule ;
- la figure 6 illustre une vue en coupe d'un exemple d'empilement de couches minces obtenu à la suite d'une étape de décollement du procédé de fabrication de la structure de la cellule ;
- la figure 7 illustre une vue en coupe d'un exemple d'empilement de couches minces obtenu à la suite d'étapes de décollement et de retournement, suivi de dépôt de couches dans le procédé de fabrication de la structure de la cellule ;
- la figure 8 est un diagramme de représentation illustrant les principales étapes du procédé de fabrication de la structure de cellule photovoltaïque ;
- la figure 9 illustre des exemples de résultats de densité de courant par rapport à une tension, obtenus avec une structure selon l'invention et en comparaison à ceux obtenus avec deux structures de cellule classiques ;
- la figure 10 illustre une vue en coupe d'un exemple d'empilement de couches minces de la structure de cellule avec une couche d'interface CI entre une couche avant conductrice CA et la couche d'alliage photovoltaïque CIGS, et
- la figure 11 représente des courbes 100 et 102 de densité de courant par rapport à une tension appliquée, obtenues avec une structure selon l'invention respectivement sans et avec la couche d'interface CI de la figure 10.

Pour des raisons de clarté, les dimensions des différents éléments représentés sur ces figures ne sont pas nécessairement en proportion avec leurs dimensions réelles. Sur les figures, des références identiques correspondent à des éléments identiques.

L'invention propose une structure de cellule photovoltaïque en couches minces pour la conversion d'une lumière d'éclairement en électricité.

Ainsi, en référence à la figure 2, on a représenté une vue en coupe d'un exemple de réalisation d'une telle structure avec une cellule 2 photovoltaïque. Dans ce mode de réalisation, on prend l'exemple selon lequel l'alliage composant la couche d'alliage I-III-VI₂ de la cellule 2 est du CIGS.

La structure de la cellule 2 comprend un support S qui peut être, à titre illustratif, du verre, un polymère ou autre. Comme décrit plus loin, le support S peut avoir une température de fusion inférieure ou égale à 500°C. Sur ce support S, il est disposé un empilement de couches minces dont :
- une couche miroir MR ;
- une couche C5 contenant de l'oxyde de zinc (ZnO) ;
- une couche tampon CT à base par exemple de sulfure de cadmium (CdS), de sulfure de zinc (ZnS), ou de sulfure d'indium (In₂S₃) ;
- une couche CIGS d'une épaisseur inférieure ou égale à 0,5 micron et donc composée de CIGS ;
- une couche avant CA transparente et conductrice, disposée en avant de la cellule 2 et qui peut être composée, à titre purement illustratif, d'un matériau conducteur et transparent tel que l'oxyde de zinc (ZnO) ; et
- une couche ENC d'encapsulation transparente à la lumière d'éclairement.

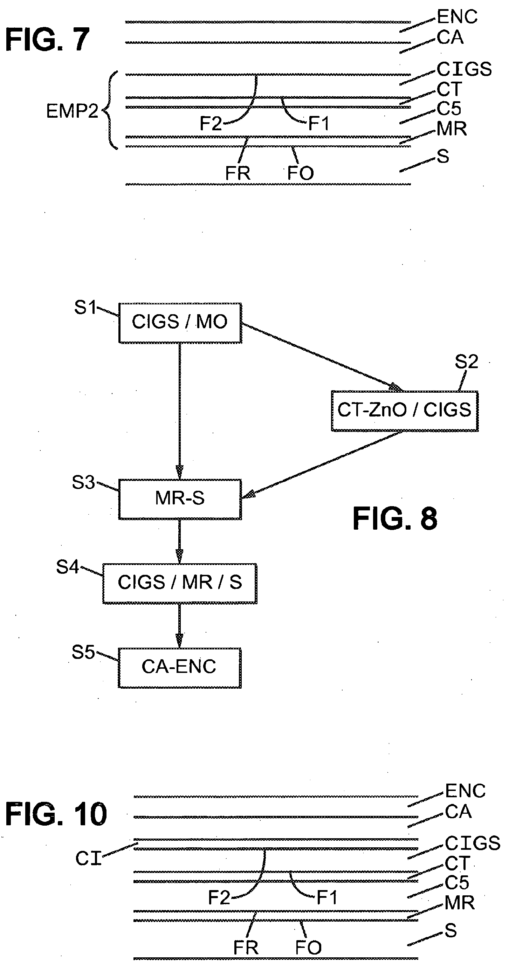

En outre, selon une réalisation avantageuse, une couche d'interface transparente (comme observé plus loin aux figures 10 et 11) peut être disposée entre la couche avant CA et 1a couche CIGS pour améliorer les propriétés électriques de l'interface des deux couches.

Selon cet exemple de réalisation, la cellule 2 comporte des moyens d'intégration à un panneau solaire (non représenté sur les figures) et est éclairée par une source lumineuse 8 telle que le soleil.

La couche miroir MR de la cellule 2 comporte une face réfléchissante FR d'une partie de la lumière d'éclairement, et donc d'une partie des rayons lumineux la. La face réfléchissante FR est en regard d'une première face F1 de la couche CIGS pour recevoir via cette première face F1 une lumière d'éclairement réfléchie selon les rayons lumineux réfléchis 1b. La lumière d'éclairement réfléchie peut avantageusement être diffuse, en particulier par l'intermédiaire d'effets de texturation sur la face réfléchissante FR.

La couche avant CA et la couche d'encapsulation ENC de la cellule 2 sont transparentes à la lumière d'éclairement en provenance de la source 8 pour que la couche CIGS reçoive une lumière d'éclairement transmise sur la deuxième face F2 opposée à la première face F1.

Avantageusement, la couche d'encapsulation ENC, en superficie de la couche avant CA dans cet exemple, se compose d'un matériau encapsulant tel que du plastique (par exemple à base de polycarbonate, téréphtalate, polyacrylique, polyéthylène, ou autre), du verre, ou autre. Dans une variante, la couche d'encapsulation ENC transparente peut être directement collée à la deuxième face F2 de la couche CIGS, auquel cas la couche d'encapsulation ENC comprend un matériau conducteur.

La couche CIGS présente une épaisseur relativement fine, typiquement inférieure ou égale à 0,5 micron, de sorte qu'au moins une partie de la lumière d'éclairement en provenance de la source 8 traverse cette couche CIGS. Ainsi, une partie du rayonnement lumineux, représenté par les rayons lumineux 1a en provenance de la source 8, traverse la couche CIGS, via la deuxième face F2, et parvient à la face réfléchissante FR de la couche miroir MR. Les rayons lumineux 1a sont alors réfléchis par la face réfléchissante FR selon des rayons lumineux réfléchis 1b qui traversent à nouveau la couche CIGS. Ainsi, un rayonnement lumineux réfléchi, représenté par les rayons lumineux réfléchis 1b, peut être absorbé dans la couche de CIGS et générer de l'énergie par effet photovoltaïque. La couche CIGS est exposée à un éclairement direct (rayons lumineux 1a) et à un éclairement réfléchi (rayons lumineux réfléchis 1b) concourant à un rendement supérieur de la cellule 2 par rapport à une cellule sans un tel éclairement réfléchi.

En référence à la figure 3, on a représenté le rayonnement du flux lumineux traversant la couche d'alliage photovoltaïque. La partie 30 de la courbe représente la décroissance du rayonnement alumineux direct du flux traversant la couche d'alliage depuis la première face F1 vers la deuxième face F2. La partie 31 de la courbe représente le rayonnement lumineux direct du flux non exploité lorsque la cellule ne comporte pas de couche miroir. Lorsque la cellule comprend la couche miroir MR, la partie 32 de la courbe présente le rayonnement réfléchi qui traverse à nouveau la couche d'alliage photovoltaïque, depuis la deuxième face F2 vers la première face F1. Ainsi, on comprend que la couche miroir MR permet d'augmenter le rayonnement lumineux traversant la couche d'alliage de la cellule photovoltaïque.

Selon cet exemple de réalisation, la face réfléchissante FR est en regard de la première face F1 de la couche CIGS par l'intermédiaire d'une couche C5 et d'une couche tampon CT. La couche C5 est avantageusement composée d'un matériau conducteur transparent tel que l'oxyde de zinc (ZnO) pouvant être déposé à basse température, inférieure à 200°C par exemple. Comme précité, la couche tampon CT est quant à elle à base de sulfure de cadmium (CdS), de sulfure de zinc (ZnS), de sulfure d'indium (In₂S₃) ou autre.

On comprendra toutefois que ce mode de réalisation de l'invention n'est pas limitatif et que la couche miroir MR peut être en contact direct avec la couche CIGS sur sa première face F1 ou par l'intermédiaire uniquement d'une seule couche tampon CT transparente, voire même d'un simple traitement de surface de la première face F1.

La couche miroir MR et l'une des couches de la couche avant CA et de la couche d'encapsulation ENC, ici sont conductrices de manière à former chacune une électrode de la cellule 2. Avantageusement, d'une part, la couche MR est une électrode en regard de la première face F1 de la couche CIGS (électrode arrière). D'autre part, l'une des couches de la couche avant CA et de la couche d'encapsulation ENC est une électrode en regard de la deuxième couche F2 de la couche CIGS (électrode avant). A titre d'exemple non limitatif, la couche avant CA est la cathode de la cellule 2 et la couche miroir MR est l'anode.

Selon cet exemple de réalisation, le support S est au contact d'une face opposée FO à la face réfléchissante FR de la couche miroir MR. Le support S peut être amené par collage à la face opposée FO. Toutefois, d'autres procédés peuvent être envisagés pour solidariser le support S sur la couche miroir MR, notamment thermiques.

La couche miroir MR peut être un métal conducteur ou un revêtement réfléchissant, lesquels diffusent une lumière réfléchie au travers de la couche de CIGS. Lorsque le revêtement réfléchissant n'est pas conducteur, l'électrode arrière de la cellule est constituée par une des secondes couches transparentes, typiquement, par la couche conductrice C5 par exemple. Le revêtement réfléchissant peut être composé de couches réfléchissantes dites couches « blanches ».

En outre, le support S de la structure de couches minces de la cellule 2 peut être léger et flexible, comme un polymère souple par exemple. Le support S étant amené par collage à un empilement de couches minces comprenant déjà la couche CIGS formée, le support S peut avoir une température de fusion basse (inférieure à 500°C par exemple) sans risque d'être dégradé par le procédé de formation de la couche de CIGS (coévaporation à 550°C).

Selon une autre réalisation, l'empilement des couches minces est réalisé directement à partir du support S, auquel cas le support S a une température de fusion plus élevée (de préférence supérieure à 550°C) résistant ainsi au procédé de formation de la couche CIGS (exposition à des températures entre 400 et 550°C). Selon cette réalisation, le support S peut être recouvert tout d'abord de la couche miroir MR sur laquelle seront déposées la couche conductrice C5 et la couche tampon CT. La couche de CIGS est alors appliquée sur la couche tampon CT avant de recevoir la couche avant CA transparente et conductrice. La couche C5 et la couche tampon CT peuvent être prévues pour établir une liaison semi-conductrice entre la couche miroir MR et la couche d'alliage CIGS.

On se réfère maintenant à la figure 8 sur laquelle sont illustrées les principales étapes du procédé de fabrication de la structure de la cellule photovoltaïque.

Selon une étape S1, une couche d'alliage I-III-VI₂ est déposée à la surface d'un substrat (ou plus communément à la surface d'une couche de molybdène Mo). La face de la couche d'alliage I-III-VI₂, dénommée ci-avant «deuxième face » F2 de la couche d'alliage I-III-VI₂, est en contact avec la surface précitée et est destinée à recevoir la lumière d'éclairement en transmission. Le dépôt de la couche d'alliage I-III-VI₂ est avantageusement réalisé selon un procédé de coévaporation sous vide à haute température, notamment dans le cadre d'un alliage I-III-VI₂ de type CIGS. Bien entendu, d'autres techniques de dépôt sont envisageables (électrolyse ou autre).

Selon une étape S2, une ou plusieurs couches transparentes sont déposées sur la couche d'alliage I-III-VI₂ déposée à l'étape S1. Ce dépôt est réalisé sur la première face F1 de la couche d'alliage I-III-VI₂ (laquelle première face F1 est opposée à la deuxième face F2).

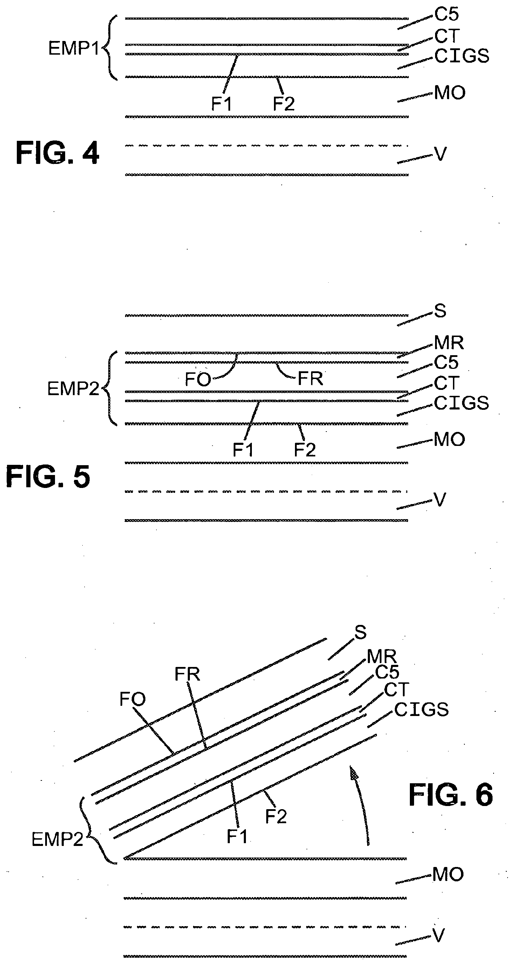

En référence à la figure 4, on a représenté un exemple de structure en couches minces obtenu à la suite des étapes S1 et S2, comprenant le substrat V (revêtu ici d'une couche MO à base de molybdène) sur lequel est déposée la couche CIGS d'alliage I-III-VI₂. Selon l'exemple représenté, le substrat V est à base de verre. Il peut être prévu sur la couche MO un empilement EMP1 de couches minces issu de la superposition :
- d'une couche CIGS d'une épaisseur inférieure ou égale à 0,5 micron,
- d'une couche tampon CT, puis
- d'une couche C5 transparente et conductrice.

La couche tampon CT peut être déposée, par exemple, à basse température par voie chimique en solution aqueuse selon une méthode de dépôt par bain chimique (dite «Chemical Bath Déposition (CBD)» en anglais). Lorsque la couche tampon CT est formée, la couche C5 d'oxyde de zinc (ZnO) est déposée par pulvérisation réactive (dite « sputtering » en anglais).

Selon une étape S3, la couche miroir MR est déposée directement sur la première face F1 de la couche d'alliage I-III-VI₂ (à l'issue de l'étape S1) ou indirectement via la couche C5 (à l'étape S2). La couche miroir MR peut être déposée avec éventuellement un traitement de surface préalable comme une texturation de la face réfléchissante par exemple.

Selon cette même étape S3, un support S peut être appliqué à l'empilement de couches obtenu à l'issue du dépôt de la couche miroir MR. Le support S peut être amené par collage sur la face opposée FO de la couche miroir MR.

A ce stade, la structure de couches minces n'est plus amenée à être exposée à de hautes températures (notamment induites par le procédé de dépôt de la couche d'alliage I-III-VI₂ à l'étape S1) et ainsi, le support amené par collage peut être composé d'un matériau à température de fusion inférieure à 300°C, comme un polymère souple par exemple.

En référence à la figure 5, on a représenté un exemple de structure en couches minces obtenu à la suite des étapes S1, S2 et S3, et comportant l'empilement EMP2, avec :
- la couche CIGS ;
- la couche tampon CT ;
- la couche C5 transparente et conductrice ; et
- la couche miroir MR.

On a également représenté le support S (par exemple un polymère souple à basse température de fusion) pouvant être amené par collage sur l'empilement EMP2, notamment sur la face opposée FO de la couche miroir MR.

Selon une étape S4, un décollement de l'interface entre la couche d'alliage I-III-VI₂ et la couche MO de molybdène est réalisé. En effet, l'interface entre le CIGS et le molybdène présente un faible coefficient d'adhésion. Elle est réputée peu stable mécaniquement et le CIGS tend à se décoller facilement du molybdène. Bien entendu, d'autres matériaux que le molybdène peuvent être prévus à cet effet.

Ce décollement peut être réalisé par action de tirage sur le support S (dite « lift-off » en anglais). Le support S peut d'ailleurs être renforcé par l'adjonction temporaire d'une couche complémentaire en vue de l'action de tirage. Cette technique permet d'exploiter le faible coefficient d'adhésion présenté classiquement par une interface d'une couche de CIGS et d'une couche de molybdène pour faciliter la séparation de l'empilement EMP2 de la couche de molybdène MO et du substrat V. De cette manière, les contraintes mécaniques subies par la couche de CIGS sont moindres, préservant ainsi l'intégrité de la couche et conservant donc les performances de la cellule.

Le décollement à l'interface entre la couche d'alliage I-III-VI₂ et le substrat permet de libérer la deuxième face F2 de la couche d'alliage I-III-VI₂ du substrat pour recevoir, comme on le verra plus loin un éclairement en transmission.

En référence à la figure 6, on a représenté une vue en coupe d'un exemple d'empilement de couches minces obtenu à la suite de l'étape S4 de décollement.

Avantageusement, suite au décollement de l'étape S4, le substrat V et la couche MO peuvent être réutilisés pour la fabrication d'autres structures de cellule photovoltaïque (notamment selon les étapes précédentes du procédé de fabrication).

A l'issue de l'étape S4, l'empilement de couches décollé du substrat V et de la couche MO comprend au moins la couche de CIGS, la couche miroir MR et le support S.

Selon une étape S5, l'empilement de couches minces décollé du substrat à l'étape S4 est retourné. Sur l'empilement de couches minces décollé sont déposées une ou plusieurs couches transparentes CA, ENC. Ces couches transparentes sont déposées sur la deuxième face F2 de la couche d'alliage I-III-VI₂, laquelle a été libérée à la suite du décollement avec le substrat. Ainsi, la couche CIGS reçoit un éclairement en transmission par l'intermédiaire des couches transparentes déposées sur sa face F2.

En référence à la figure 7, on a représenté une vue en coupe d'un exemple d'empilement de couches minces obtenu à la suite de l'étape S5 de retournement et de dépôt de couches transparentes. On y observe l'empilement EMP2 retourné et sur lequel sont déposées la couche avant CA transparente et conductrice formant une électrode avant de la cellule et la couche d'encapsulation ENC pour protégeant l'empilement de couches de la cellule.

Dans cet exemple de réalisation, comme précité, le support S est ajouté à l'étape S3, à la suite du dépôt de la couche miroir MR. Toutefois, on comprendra que le support S peut être amené par collage selon l'une quelconque des étapes S4 et S5.

On se réfère maintenant à la figure 9 sur laquelle sont illustrés des exemples de caractéristiques photovoltaïques mesurées sous éclairement solaire d'une puissance de 1000 W/m² et selon une variation du courant en fonction d'une tension appliquée, pour :
- une structure de cellule classique avec une couche de CIGS d'une épaisseur de 2,5 microns déposée sur une couche de molybdène (courbe 80),
- une structure de cellule classique avec une couche de CIGS d'une épaisseur de 0,4 micron déposée sur une couche de molybdène (courbe 82), et
- une structure de cellule au sens de l'invention, formée suite aux étapes S1, S3, S4 et S5 précitées, et comprenant une couche miroir MR à base d'or (Au) avec une couche de CIGS d'une épaisseur de 0,4 micron (courbe 84).

On indique ici que plus la valeur absolue de la densité (en mA.cm⁻²) est élevée, plus le rendement de la cellule photovoltaïque est performant.

A la vue de la courbe 80, on comprend ainsi que la structure classique avec une couche de CIGS d'une épaisseur de 2,5 microns propose les meilleurs résultats au regard des deux autres structures. Toutefois, on observe que la structure avec une couche miroir MR (courbe 84) permet d'obtenir des performances plus élevées qu'une structure classique (courbe 82) ayant pourtant une même épaisseur de couche de CIGS. La couche miroir MR de la cellule permet donc de proposer un rendement supérieur à une cellule classique pour une même quantité de matière, par exemple, d'indium dans le cadre de cellules à base de CIGS.

On se réfère maintenant à la figure 10, sur laquelle on a représenté la couche d'interface précitée CI intercalée entre la couche avant CA transparente et conductrice, et la couche d'alliage photovoltaïque CIGS. La couche d'interface CI peut être un semi-conducteur, transparent, à grand gap (supérieur à 2eV par exemple) déposé en couche mince de fine épaisseur (inférieure à 100 nm par exemple). La couche d'interface CI transparente est prévue pour former un contact ohmique entre la couche avant CA et la couche CIGS. Avantageusement, la couche d'interface CI peut en outre être dopée p selon un taux supérieur à celui de la couche CIGS.

En variante, la couche d'interface CI peut être une couche de cuivre (Cu) d'une épaisseur de quelques nanomètres.

En référence à la figure 11, on a représenté les variations obtenues du courant en fonction d'une tension appliquée pour :
- la courbe 100, une configuration de cellule sans la couche d'interface CI (telle qu'illustrée à la figure 2) ; et
- la courbe 102, une configuration de cellule avec la couche d'interface CI (telle qu'illustrée à la figure 9).

Dans cet exemple, la couche avant CA est constituée d'oxyde de zinc (ZnO) dopé à l'aluminium de sorte à former une couche transparente et conductrice.

Au regard de la courbe 100, lorsque la couche avant CA est directement en contact avec la couche CIGS, la jonction électrique est partiellement bloquante et suit le comportement électrique d'une diode ce qui n'est pas souhaitable pour une cellule photovoltaïque.

D'après la courbe 102, le contact obtenu via la couche d'interface CI intercalée entre la couche avant CA et la couche CIGS est ohmique et peu résistif. Le comportement électrique de l'interface présente alors un passage du courant directement proportionnel à la tension appliquée, permettant le passage du courant en évitant un blocage électrique et la recombinaison d'électrons, ceci pour une résistance du contact inférieure à 1 Ω.cm⁻², ce qui est avantageux dans le cadre d'une utilisation en tant qu'électrode.

Ainsi, on comprendra qu'une structure de cellule photovoltaïque avec une couche miroir et une épaisseur d'alliage I-III-VI₂ d'une épaisseur inférieure ou égale à 0,5 micron, permet d'obtenir un rendement sensiblement équivalent aux structures des cellules classiques ayant une épaisseur d'alliage I-III-VI₂ généralement de 2 microns.

Bien entendu, la présente invention ne se limite pas à la forme de réalisation décrite ci-avant à titre d'exemple et elle s'étend à d'autres variantes. A ce titre, selon un autre mode de réalisation, la couche d'alliage I-III-VI₂ peut être déposée directement sur un empilement de couches comprenant en particulier la couche miroir MR avec une face réfléchissante en regard d'une premières face de la couche d'alliage I-III-VI₂. Selon ce mode de réalisation, la fabrication de la structure ne requiert pas de décollement de la structure.

## Revendications

1. Structure de cellule photovoltaïque en couches minces comportant au moins une couche d'alliage I-III-VI₂ (CIGS) à propriétés photovoltaïques, pour la conversion d'une lumière d'éclairement en électricité, l'au moins une couche d'alliage I-III-VI₂ (CIGS) à propriétés photovoltaïques étant superposée dans la structure entre :
- une ou plusieurs premières couches (CA, ENC) transparentes à ladite lumière d'éclairement, dont au moins une première couche conductrice (CA) jouant le rôle d'une électrode avant conductrice de la cellule photovoltaïque ;
- une deuxième couche conductrice (C5, MR), jouant le rôle d'une électrode arrière conductrice de la cellule photovoltaïque ;
**caractérisée en ce que** ladite structure comporte au moins:
une couche tampon (CT) entre l'au moins une couche d'alliage I-III-VI₂ (CIGS) à propriétés photovoltaïques et la deuxième couche conductrice (C5,MR) pour former une jonction p-n
- une couche miroir (MR) comportant une face réfléchissante (FR) d'une partie de la lumière d'éclairement, la face réfléchissante (FR) étant en regard d'une première face (F1) de la couche d'alliage I-III-VI₂ (CIGS), pour recevoir sur ladite première face une lumière d'éclairement réfléchie, et
- une couche intercalaire (CI) transparente, de contact ohmique peu résistif, entre ladite couche transparente conductrice (CA) et ladite couche d'alliage I-III-VI₂ (CIGS),
l'une ou plusieurs premières couches (CA, ENC) recevant une lumière d'éclairement transmise sur une deuxième face (F2) de la couche d'alliage I-III-VI₂ (CIGS), opposée à la première face (F1),
la couche d'alliage I-III-VI₂ (CIGS) à propriétés photovoltaïques ayant une épaisseur relativement fine, de sorte qu'au moins une partie de la lumière d'éclairement traverse cette couche.

2. Structure de cellule photovoltaïque selon la revendication 1, **caractérisée en ce que** ladite couche miroir (MR) est une couche métallique conductrice.

3. Structure de cellule photovoltaïque selon la revendication 1, **caractérisée en ce que** ladite couche miroir (MR) est non métallique et diffusive, et comprend un revêtement réfléchissant.

4. Structure de cellule photovoltaïque selon l'une des revendications précédentes, **caractérisée en ce que** la face réfléchissante (FR) de la couche miroir (MR) est en regard de la première face (F1) de la couche d'alliage I-III-VI₂ (CIGS), par l'intermédiaire d'une ou plusieurs secondes couches (CT, C5) transparentes à ladite lumière d'éclairement, dont l'une au moins (C5) est transparente et électriquement conductrice.

5. Structure de cellule photovoltaïque selon l'une des revendications précédentes, **caractérisée en ce que** la ou lesdites premières couches (CA, ENC) transparentes comportent au moins un revêtement superficiel d'encapsulation.

6. Structure de cellule photovoltaïque selon l'une des revendications précédentes, **caractérisée en ce que** ladite couche d'alliage I-III-V1₂ (CIGS) est d'une épaisseur inférieure ou égale à 0,5 micron.

7. Structure de cellule photovoltaïque selon l'une des revendications précédentes, **caractérisée en ce qu'**elle comporte des moyens d'intégration à un panneau solaire, ladite lumière d'éclairement étant la lumière du soleil.

## Patentansprüche

1. Photovoltaische Dünnschichtzellenstruktur, die mindestens eine Schicht aus I-III-VI₂-Legierung (CIGS) mit photovoltaischen Eigenschaften aufweist, zum Umwandeln von einem Beleuchtungslicht in Strom, wobei die mindestens eine Schicht aus I-III-VI₂ -Legierung (CIGS) mit photovoltaischen Eigenschaften in der Struktur zwischen Folgendem eingebunden ist:
- einer oder mehreren ersten Schichten (CA, ENC), die für das Beleuchtungslicht transparent sind, wovon mindestens eine erste leitende Schicht (CA) als leitende Frontelektrode der photovoltaischen Zelle fungiert;
- einer zweiten leitenden Schicht (C5, MR), die als eine leitende Rückelektrode der photovoltaischen Zelle fungiert;
**dadurch gekennzeichnet, dass** die Struktur mindestens Folgendes aufweist:
- eine Pufferschicht (CT) zwischen der mindestens einen Schicht aus I-III-VI₂-Legierung (CIGS) mit photovoltaischen Eigenschaften und der zweiten leitenden Schicht (C5, MR), um eine Verbindung p-n zu bilden;
- eine Spiegelschicht (MR), die eine reflektierende Seite (FR) eines Teils des Beleuchtungslichtes aufweist, wobei die reflektierende Seite (FR) einer ersten Seite (F1) der Schicht aus I-III-VI₂-Legierung (CIGS) gegenüberliegend ist, um auf der ersten Seite ein reflektiertes Beleuchtungslicht zu empfangen, und
- eine transparente Zwischenschicht (CI) mit geringem ohmschen Widerstand zwischen der leitenden transparenten Schicht (CA) und der Schicht aus I-III-VI₂-Legierung (CIGS),
wobei die eine oder mehreren ersten Schichten (CA, ENC) ein Beleuchtungslicht empfangen, das auf eine zweite Seite (F2) der Schicht aus I-III-VI₂-Legierung (CIGS) übertragen wird, die der ersten Seite (F1) gegenüberliegend ist,
wobei die Schicht aus I-III-VI₂ -Legierung (CIGS) mit photovoltaischen Eigenschaften eine relativ dünne Dicke aufweist, sodass mindestens ein Teil des Beleuchtungslichtes diese Schicht durchquert.

2. Photovoltaische Zellenstruktur nach Anspruch 1, **dadurch gekennzeichnet, dass** die Spiegelschicht (MR) eine leitende Metallschicht ist.

3. Photovoltaische Zellenstruktur nach Anspruch 1, **dadurch gekennzeichnet, dass** die Spiegelschicht (MR) nicht-metallisch und diffusiv ist und eine reflektierende Beschichtung aufweist.

4. Photovoltaische Zellenstruktur nach einem der vorhergehenden Ansprüche, **dadurch gekennzeichnet, dass** die reflektierende Seite (FR) der Spiegelschicht (MR) der ersten Seite (F1) der Schicht aus I-III-VI₂-Legierung (CIGS) eine oder mehrere zweite Schichten (CT, C5) gegenüberliegend ist, die für das Beleuchtungslicht transparent sind, wovon mindestens eine (C5) transparent und elektrisch leitend ist.

5. Photovoltaische Zellenstruktur nach einem der vorhergehenden Ansprüche, **dadurch gekennzeichnet, dass** die erste oder die ersten transparenten Schichten (CA, ENC) mindestens eine Oberflächenbeschichtung zur Verkapselung aufweisen.

6. Photovoltaische Zellenstruktur nach einem der vorhergehenden Ansprüche, **dadurch gekennzeichnet, dass** die Schicht aus I-III-VI₂-Legierung (CIGS) von einer Dicke von weniger als oder gleich 0,5 Mikron ist.

7. Photovoltaische Zellenstruktur nach einem der vorhergehenden Ansprüche, **dadurch gekennzeichnet, dass** sie Mittel zur Integration in ein Solarpanel aufweist, wobei das Beleuchtungslicht das Sonnenlicht ist.

## Claims

1. Thin layer photovoltaic cell structure comprising at least one I-III-VI₂ alloy layer (CIGS) with photovoltaic properties for the conversion of illuminating light into electricity, the at least one I-III-VI₂ alloy layer (CIGS) with photovoltaic properties being placed in the structure between:
- one or more first layers (CA, ENC) transparent to the illuminating light, which comprise at least one conducting layer (CA), playing the role of a front photovoltaic cell electrode,
- one second conducting layer (C5, MR), playing the role of a back photovoltaic cell electrode,
**characterized in that** sait structure comprises at least:
- one buffer layer CT between the at least one I-III-VI₂ alloy layer (CIGS) with photovoltaic properties and the second conducting layer (C5, MR) forming a p-n junction;
- one mirror layer (MR) comprising a surface (FR) reflecting a part of the illuminating light, where said reflecting surface (FR) is facing a first face (F1) of the I-III-VI₂ alloy layer (CIGS) for receiving reflected illuminating light on said first face; and
- one low resistance ohmic contact intermediate layer between the conducting layer (CA) and said I-III-VI₂ alloy layer (CIGS),
one or more first layers (CA, ENC) transparent to the illuminating light for receiving transmitted illuminating light on a second face (F2) of the I-III-VI2 alloy layer opposite to the first face (F1),
the I-III-VI₂ alloy layer (CIGS) with photovoltaic properties having a reduced thickness, so that at least a part of the illuminating light passes through this layer.

2. Photovoltaic cell structure according to claim 1, **characterized in that** said mirror layer (MR) is a conducting metal layer.

3. Photovoltaic cell structure according to claim 1, **characterized in that** said mirror layer (MR) is nonmetallic and diffusive, and includes a reflective coating.

4. Photovoltaic cell structure according to one of the preceding claims, **characterized in that** the reflecting surface (FR) of the mirror layer (MR) is across from the first face (F1) of the I-III-VI2 alloy layer (CIGS), with one or more intermediate second layers (CT, C5) transparent to said illuminating light, of which at least one (C5) is transparent and electrically conducting.

5. Photovoltaic cell structure according to one of the preceding claims, **characterized in that** the one or more transparent first layers (CA, ENC) comprises at least one surface coating for encapsulation.

6. Photovoltaic cell structure according to one of the preceding claims, **characterized in that** said I-III-VI₂ alloy layer (CIGS) is less than or equal to 0.5 µm thick.

7. Photovoltaic cell structure according to one of the preceding claims, **characterized in that** it comprises means for incorporation in a solar panel, where said illuminating light is sunlight.
